# EUROPEAN PATENT SPECIFICATION

(11) **EP 2 840 305 B1**
(45) Date of publication and mention of the grant of the patent: **18.07.2018**
(21) Application number: 12874822.5
(22) Date of filing: 27.07.2012
(51) Int. Cl.: F21V 7/00, B29C 39/00

(54) **METHOD FOR PREPARING REFLECTOR**
VERFAHREN ZUR HERSTELLUNG EINES REFLEKTORS
MÉTHODE DE PRÉPARATION D'UN RÉFLECTEUR

(30) Priority: 17.04.2012 KR 20120039648
(43) Date of publication of application: 25.02.2015
(73) Proprietor: Alto Co. Ltd., Seoul 135-935 (KR); Altek Technologies Co. Ltd., Seoul 135-935 (KR)
(72) Inventor: HUH, Seung-Hyo, Seoul 137-836 (KR); HUH, Yoon Soo, Seoul 135-894 (KR)
(74) Representative: Cabinet Le Guen Maillet
(86) International application number: PCT/KR2012/006015
(87) International publication number: WO 2013/157700

(56) References cited:
- EP-A1- 2 163 581
- WO-A1-2012/014679
- JP-A- H09 183 130
- JP-A- H09 183 130
- KR-A- 19990 070 113
- KR-A- 20090 009 983
- KR-B1- 100 800 952
- US-B1- 6 406 601

## Description

### Technical Field

The present invention relates to a method of manufacturing a reflector, and more particularly, to a method of manufacturing a reflector, which may reflect light of a light source so as to concentrate such light.

### Background Art

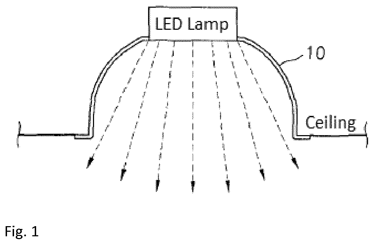

A lighting device employs any type of reflector to allow light emitted from a light source to efficiently concentrate in an angle range able to effectively apply light to a lighting target. In order to increase the efficiency of the lighting device, a reflector 10 is used to apply light in a desired direction from a light source as illustrated in FIG. 1.

With the goal of increasing the reflectance of the reflector 10, the surface of the reflector is plated with a thin film. Although the plated thin film exhibits high reflectance, its surface is not smooth and thereby may cause intense diffuse reflection of light. Such diffuse reflection incurs problems of glare for a user. WO2012014679 A, EP2163581 A and JP09-183130 A each show methods for making reflectors in which an injection molded plastic product is produced and a metal reflective layer is deposited on its surface by vapour deposition.

### Disclosure

### Technical Problem

Accordingly, an object of the present invention is to provide a reflector having increased reflectance. Also, another object of the present invention is to provide a reflector having decreased luminance to prevent glare. Also, a further object of the present invention is to provide a method of simply manufacturing a reflector, which may prevent glare while increasing the reflectance of the reflector.

### Technical Solution

An embodiment of the present invention provides a method according to claim 1 of manufacturing a reflector for reflecting light of a light source to concentrate the light, comprising: producing an injection-molded plastic product using a mold; subjecting the surface of the injection-molded plastic product to ultrasonic cleaning; and depositing an aluminum thin film on the surface of the injection-molded plastic product.

Also, the method comprises subjecting the surface of the injection-molded plastic product to plasma surface treatment, before depositing the aluminum thin film. Also, the method may further comprise performing UV coating on the surface of the injection-molded plastic product, after depositing the aluminum thin film. Also, the mold used to produce the injection-molded plastic product may be a mold having a flat inner surface created by a lapping process. Also, the injection-molded plastic product may be formed using polycarbonate or an acrylonitrile-butadiene-styrene (ABS) resin.

### Advantageous Effects

According to embodiments of the present invention, the reflectance of a reflector for reflecting light of a light source to concentrate such light can be increased, and also glare from the reflector can be prevented. Also, a reflector manufacturing process for increasing reflectance of the reflector and preventing glare from the reflector can be simplified, thus reducing the manufacturing cost.

### Description of Drawings

FIG. 1 is a perspective view illustrating a light source and a reflector;
FIG. 2 is a flowchart illustrating a process of manufacturing a reflector according to an embodiment of the present invention;
FIG. 3 is of views illustrating the luminance values of a conventionally plated reflector and an aluminum-deposited reflector according to an embodiment of the present invention; and
FIG. 4 is a graph illustrating the reflectance of the aluminum-deposited reflector according to the embodiment of the present invention.

### Mode for Invention

Hereinafter, a detailed description will be given of embodiments of the present invention with reference to the appended drawings. However, the present invention is not limited to such embodiments and may be modified variously in many different forms. The embodiments are provided to complete the disclosure of the present invention and to allow those having ordinary skill in the art to understand the scope of the present invention. Throughout the specification, the same reference numerals are used to designate the same elements.

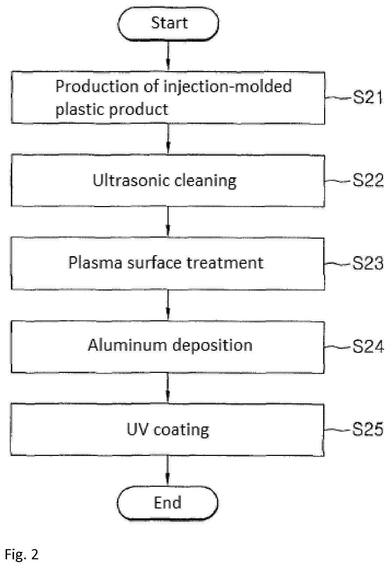

FIG. 2 is a flowchart illustrating a process of manufacturing a reflector for use in an LED lighting device according to an embodiment of the present invention.

A reflector typically useful in an LED lighting device is manufactured by depositing aluminum on the surface of an injection-molded plastic product. In order to facilitate the deposition of aluminum in the related art, a release agent is applied on the inner surface of a mold and then the injection-molded plastic product is produced. The release agent plays a role in preventing the injection-molded plastic product from being adhered to the inner surface of the mold and in easily removing the product from the mold. Such a release agent may be silicone resin that is applied on the inner surface of the mold so that the surface of the injection-molded plastic product is made flat and well-finished. However, when the injection-molded plastic product is produced using the mold coated with the release agent, removal of the release agent should be preceded before deposition of aluminum on the injection-molded plastic product. In the case where aluminum is deposited without the removal of the release agent, adhesiveness may be remarkably deteriorated, making it impossible to ensure quality of the reflector. Furthermore, the removal of the release agent is cumbersome and complete removal thereof is difficult. Therefore, although a coating process with the release agent is conventionally performed in order to increase mass productivity of the injection-molded plastic product using the mold, the use of the release agent may cause the quality of deposited aluminum to deteriorate.

Hence, an embodiment of the present invention is intended to improve mass productivity via injection molding and quality of deposited aluminum, without the use of the release agent. To ensure mass productivity via the injection molding process, an injection-molded plastic product is produced using a mold subjected to a lapping process which enables the inner surface of the mold to be smooth and flat. Also, in order to increase quality of aluminum to be deposited on the surface of the injection-molded plastic product, two cleaning treatments, namely ultrasonic cleaning and plasma surface treatment, are carried out before deposition of aluminum.

Individual procedures are described below. First, an injection-molded plastic product for a reflector is produced. Injection-molded plastic products having various shapes may be manufactured depending on the kind of light source. Examples of the shape of the plastic product may include a round shape having a curvature, rectangular and triangular shapes having linearity, etc.

The reflector is manufactured using a plastic injection molding process (S21). Specifically, hot plastic is injected into a mold having a desired shape at high pressure, followed by instant cooling and removal of the injection-molded plastic product for a reflector from the mold. The plastic injected into the mold may be polycarbonate (PC) or acrylonitrile-butadiene-styrene (ABS) resin.

The mold, the inner surface of which is subjected to a lapping process, is used. As the mold has the smooth and flat inner surface created by such a lapping process, the surface of the resulting injection-molded plastic product is made smooth. When the injection molding process is performed using the mold having the inner surface created by the lapping process, there is no need to apply a release agent on the surface of the injection-molded plastic product.

After the production of the injection-molded plastic product using the mold having the lapped inner surface, ultrasonic cleaning, which is a primary cleaning process, is carried out (S22). As such, ultrasonic cleaning is based on the following principle. Specifically, when ultrasonic waves are generated from the bottom of a vessel containing water, water may be vigorously agitated so that water bubbles float to the surface thereof. Then, when contaminated objects are placed in such water, they may be cleaned by the action of ultrasonic waves. As ultrasonic waves are applied to a liquid in which the injection-molded plastic product having impurities attached thereto is placed, liquid pressure may fluctuate and thus the surface of the injection-molded plastic product may be cleaned by erosion. Accordingly, the inner surface or narrow grooves of the injection-molded plastic product having a complicated shape may be simply cleaned. Fine impurities having a size of 10 µm or less of the injection-molded plastic product may be easily removed via ultrasonic cleaning.

After the ultrasonic cleaning, a secondary cleaning process, namely, plasma surface treatment is carried out (S23) .

The plasma surface treatment process is performed in such a manner that the surface of the product is bombarded with particles having high energy in the plasma state to remove surface impurities, thereby enabling the efficient reaction of the product with the other material in the subsequent process. When the surface of the injection-molded plastic product is treated with plasma, which is highly activated ionized gas, impurities may be completely removed from the surface of the injection-molded plastic product. For example, ion discharge generated by a plasma generator enables the surface of the injection-molded plastic product to be bombarded with ions discharged at high speed, and thus because of ion bombardment of the anode, organic/inorganic contaminants may be removed from the surface of the injection-molded plastic product. Therefore, impurities having a size of 1 µm or less may be removed through the plasma surface treatment. In some cases, plasma surface treatment before deposition of aluminum on the injection-molded plastic product may be omitted, and only the primary cleaning such as ultrasonic cleaning may be performed. On the other hand, ultrasonic cleaning may be omitted, and only the plastic surface treatment may be carried out, followed by depositing aluminum. However neither of these treatments is according to the invention. After the primary cleaning such as ultrasonic cleaning and the secondary cleaning such as plasma surface treatment, deposition of aluminum is performed (S24). Aluminum deposition is performed in such a manner that aluminum is heated to 1500°C or more in a vacuum of about 10⁻⁴ ∼ 10⁻⁶ torr and is thus evaporated, and thereby an aluminum thin film is deposited to a thickness of at least 800 ∼ 1200 A on the injection-molded plastic product made of PC or ABS. As for the aluminum deposition process, when an aluminum ingot is heated under reduced pressure (700 ∼ 740 mmHg) in a vacuum chamber, aluminum is vaporized in the form of particles in a vacuum and thus isolated to the space of the vacuum chamber. As such, when the injection-molded plastic product is passed through the top of the chamber, aluminum particles are deposited on the film, thus forming a thin layer.

After the aluminum deposition, UV coating may be further performed (S25). A coating material for use in UV coating may include an oligomer, a monomer, a photoinitiator and an additive. The UV coating process may be implemented using spraying, flow coating or the like. The deposited aluminum thin film is coated with the coating material that is curable rapidly via UV irradiation, thus improving durability and preventing contamination.

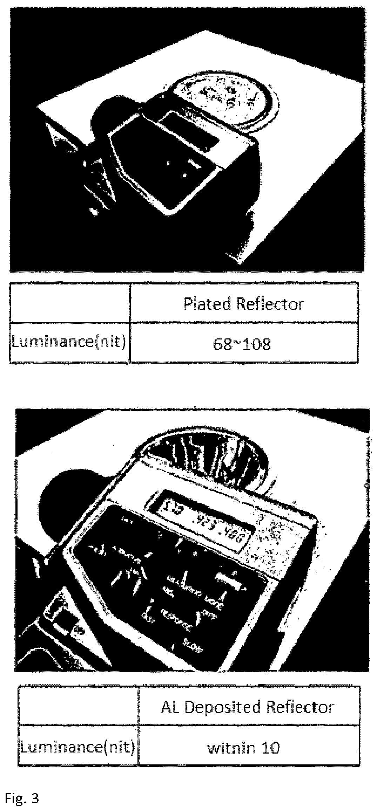

When these processes are conducted as above, reflectance may increase and luminance may decrease, thus eliminating diffuse reflection to thus alleviate glare. FIG. 3 illustrates the luminance values of the conventionally plated reflector and the aluminum-deposited reflector according to the embodiment of the present invention. Whereas the conventionally plated reflector has a luminance of 68 ∼ 100 [nit], the reflector according to the embodiment of the present invention has a low luminance within 10 [nit], thus
eliminating glare. With regard to glare, the unit thereof [nit] indicates a brightness of an object in a predetermined direction and corresponds to [cd/m2].

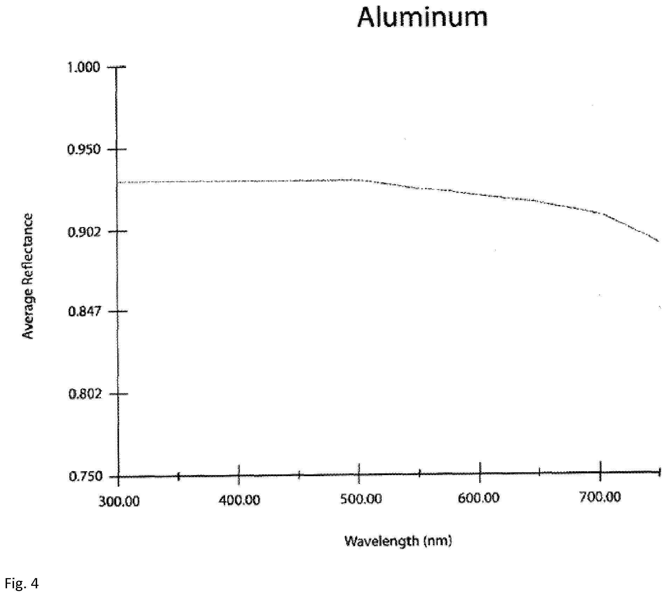

FIG. 4 illustrates the reflectance graph of the aluminum-deposited reflector according to the embodiment of the present invention. This graph shows the reflectance at different wavelengths, and the reflectance is 92% or more in the visible light range of 380 ∼ 680 nm that may be identified by the human eye.

Based on the test results of FIGS. 3 and 4, the reflector according to the present invention has high reflectance and low luminance and thus may exhibit minimum glare.

Although the preferred embodiments of the present invention have been disclosed for illustrative purposes, those skilled in the art will appreciate that various modifications, additions and substitutions are possible, without departing from the scope of the invention as disclosed in the accompanying claims.

## Claims

1. A method of manufacturing a reflector for reflecting light of a light source in an LED lighting device to concentrate the light, comprising:
producing (S21) an injection-molded plastic product using a mold;
subjecting (S22) a surface of the injection-molded plastic product to ultrasonic cleaning to remove impurity having a size of 10 *µ*m or less;
subjecting the surface of the injection-molded plastic product to plasma surface treatment (S23) to remove impurity having a size of 1 *µ*m or less; and
heating of aluminum at 1500°C or more in a vacuum chamber of 10⁻⁴ ∼ 10⁻⁶ torr to create vapor of aluminum,
depositing (S24) of vapor of aluminum in a form of an aluminum thin film on the surface of the injection-molded plastic product.

2. The method of claim 1, further comprising performing UV coating (S25) on the surface of the injection-molded plastic product, after depositing the aluminum thin film.

3. The method of claim 1, wherein the mold used to produce the injection-molded plastic product is a mold having a flat inner surface created by a lapping process.

4. The method of claim 1, wherein the aluminum thin film is deposited to a thickness of at least 800 ∼ 1200 Å.

5. The method of claim 1, wherein the injection-molded plastic product is formed using polycarbonate or an acrylonitrile-butadiene-styrene (ABS) resin.

6. The method of claim 1, wherein the injection-molded plastic product has a different shape depending on a kind of the light source.

## Patentansprüche

1. Verfahren zum Herstellen eines Reflektors zum Reflektieren von Licht einer Lichtquelle in einer LED-Beleuchtungsvorrichtung zum Konzentrieren des Lichts, das Folgendes umfasst:
Produzieren (S21) eines Spritzgusskunststoffprodukts unter Verwendung einer Form;
Aussetzen (S22) einer Oberfläche des Spritzgusskunststoffprodukts einer Ultraschallreinigung, um Verunreinigungen mit einer Größe von 10 *µ*m oder weniger zu entfernen;
Aussetzen der Oberfläche des Spritzgusskunststoffprodukts einer Plasmaoberflächenbehandlung (S23), um Verunreinigungen mit einer Größe von 1 *µ*m oder weniger zu entfernen; und
Erwärmen von Aluminium bei 1500 °C oder mehr in einer Vakuumkammer von 10⁻⁴∼10⁻⁶ Torr, um einen Aluminiumdampf zu erzeugen,
Abscheiden (S24) von Aluminiumdampf in Form eines Aluminiumdünnfilms auf der Oberfläche des Spritzgusskunststoffprodukts.

2. Verfahren nach Anspruch 1, das ferner Durchführen einer UV-Beschichtung (S25) auf der Oberfläche des Spritzgusskunststoffprodukts nach dem Abscheiden des Aluminiumdünnfilms umfasst.

3. Verfahren nach Anspruch 1, wobei die Form, die zum Produzieren des Spritzgusskunststoffprodukts verwendet wird, eine Form mit einer flachen Innenoberfläche ist, die durch einen Leitungsprozess erzeugt wird.

4. Verfahren nach Anspruch 1, wobei der Aluminiumdünnfilm zu einer Dicke von wenigstens 800-1200 Å abgeschieden wird.

5. Verfahren nach Anspruch 1, wobei das Spritzgusskunststoffprodukt unter Verwendung von Polycarbonat oder einem Acrylnitril-butadien-styrol(ABS)-Harz gebildet wird.

6. Verfahren nach Anspruch 1, wobei das Spritzgusskunststoffprodukt eine unterschiedliche Form in Abhängigkeit von einer Art der Lichtquelle aufweist.

## Revendications

1. Une méthode de préparation d'un réflecteur pour réfléchir la lumière d'une source de lumière dans un dispositif d'éclairage à DEL pour concentrer la lumière, comportant :
une production (S21) d'un produit plastique moulé par injection en utilisant un moule ;
une soumission (S22) d'une surface du produit plastique moulé par injection à un nettoyage par ultrasons pour retirer les impuretés ayant une taille de 10 *µ*m ou moins ;
une soumission de la surface du produit plastique moulé par injection à un traitement de surface par plasma (S23) pour retirer les impuretés ayant une taille de 1 *µ*m ou moins ; et
un chauffage de l'aluminium à 1500°C ou plus dans une chambre à vide de 10⁻⁴ ∼ 10⁻⁶ torr pour créer de la vapeur d'aluminium,
un dépôt (S24) de la vapeur d'aluminium sous la forme d'un fin film d'aluminium sur la surface du produit plastique moulé par injection.

2. La méthode de la revendication 1, comportant en outre une réalisation d'un revêtement UV (S25) sur la surface du produit plastique moulé par injection, après le dépôt du fin film d'aluminium.

3. La méthode de la revendication 1, où le moule utilisé pour produire le produit plastique moulé par injection est un moule ayant une surface intérieure plane créée par un procédé de rodage.

4. La méthode de la revendication 1, où le fin film d'aluminium est déposé avec une épaisseur d'au moins 800 ∼ 1200 Å.

5. La méthode de la revendication 1, où le produit plastique moulé par injection est réalisé en utilisant un polycarbonate ou une résine acrylonitrile butadiène styrène (ABS).

6. La méthode de la revendication 1, où le produit plastique moulé par injection a une forme différente selon le type de la source de lumière.
